# DEMANDE DE BREVET EUROPEEN

(11) **EP 4 478 133 A1**
(43) Date de publication de la demande: **18.12.2024**
(21) Numéro de dépôt: 23179020.5
(22) Date de dépôt: 13.06.2023
(51) Int. Cl.: G04B 19/12, A44C 27/00, C23C 14/00, G04B 37/22, G04B 45/00

(54) **PIÈCE D'HABILLAGE D'HORLOGERIE OU DE BIJOUTERIE COMPRENANT UN REVÊTEMENT GONIOCHROMATIQUE ET PROCÉDÉ DE FABRICATION DE LADITE PIÈCE**

(71) Demandeur: Rubattel et Weyermann S.A., 2300 La Chaux-de-Fonds (CH)
(72) Inventeur: BARBOS, Corina, 2300 La Chaux-de-Fonds (CH); POLY, Giovanni, 25140 Charquemont (FR); JEANRENAUD, Frédéric, 2300 La Chaux-de-Fonds (CH)
(74) Mandataire: ICB SA

(57) **Abrégé**

L'invention concerne une pièce d'habillage (10) comprenant un substrat (11) comportant, sur une surface d'habillage (110), un revêtement (12) goniochromatique composé des couches suivantes successivement superposées :
- une couche réfléchissante (121) opaque ou semi-opaque présentant une épaisseur supérieure à 100 nm,
- une couche transparente (122) ou semi transparente, présentant une épaisseur comprise entre 300 nm et 500 nm.

## Description

### Domaine technique de l'invention

L'invention relève du domaine de l'horlogerie ou de la bijouterie, et concerne plus particulièrement une pièce d'habillage d'horlogerie ou de bijouterie comprenant un revêtement conférant à ladite pièce d'habillage une couleur spécifique selon son angle d'observation, et un procédé de fabrication de ladite pièce d'habillage.

On désigne dans le présent texte par « pièces d'habillages », tout article décoratif dans les domaines de l'horlogerie ou de la bijouterie, par exemple constitué par un boitier, un cadran, une applique de cadran, un maillon de bracelet, etc. destiné à être visible.

### Arrière-plan technologique

Dans le domaine de l'horlogerie ou de la bijouterie, et plus généralement dans celui des articles décoratifs, il est connu de déposer un revêtement sur la surface d'un substrat d'une pièce d'habillage afin de lui conférer un aspect coloré.

Le revêtement peut être constitué par une ou plusieurs couches déposées par diverses méthodes de dépôt suivant l'aspect désiré. A titre d'exemple, de telles méthodes peuvent être du laquage, de la galvanoplastie, des méthodes de dépôt sous vide, en particulier des procédés de dépôt physique en phase vapeur (connu sous l'acronyme en langue anglaise « PVD » pour « Physical Vapor Déposition »), des procédés de dépôt chimique en phase vapeur (connu sous l'acronyme en langue anglaise « CVD » pour « Chemical Vapor Déposition ») et des procédés de dépôt de couche atomique (connu sous l'acronyme en langue anglaise « ALD » pour Atomic Layer Déposition).

L'aspect esthétique obtenu par la mise en oeuvre des méthodes de dépôt précités est caractérisé par une unique couleur.

Il peut cependant être recherché d'obtenir des décors plus originaux, par exemple générant des effets optiques particuliers afin d'augmenter l'attractivité de la pièce d'habillage.

### Résumé de l'invention

L'invention résout les inconvénients précités en proposant une solution permettant de réaliser une pièce d'habillage présentant un revêtement goniochromatique.

A cet effet, la présente invention concerne une pièce d'habillage comprenant un substrat comportant, sur une surface d'habillage, un revêtement goniochromatique composé des couches suivantes successivement superposées :
- une couche réfléchissante opaque ou semi-opaque présentant une épaisseur supérieure à 100 nm,
- une couche transparente ou semi transparente, présentant une épaisseur comprise entre 300 nm et 500 nm.

Grâce aux caractéristiques des couches réfléchissante et transparente, le revêtement confère à la pièce d'habillage une couleur différente selon l'angle d'observation de ladite pièce d'habillage.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la surface d'habillage du substrat comporte des structurations formées par des creux et des saillies.

Dans des modes particuliers de réalisation, la couche réfléchissante est réalisée en matériau métallique choisi parmi le nickel (Ni), l'or (Au), l'argent (Ag), le rhodium (Rh), le ruthénium (Ru), le cuivre (Cu), le chrome (Cr) et le titane (Ti).

Dans des modes particuliers de réalisation, la couche transparente est réalisée dans un matériau choisi parmi le dioxyde de silicium (SiO₂), le dioxyde de titane (TiO₂), le carbure de chrome (CrₓC_{y}), l'alumine (Al₂O₃), le dioxyde d'hafnium (HfO₂), le dioxyde de zirconium (ZrO₂), l'oxyde de tantale (Ta₂O₅), le dioxyde d'étain (SnO₂), l'oxyde d'indium-étain (ITO), l'oxyde de zinc (ZnO), l'oxyde de magnésium (MgO), le nitrure de silicium (Si₃N₄) et le nitrure d'aluminium (AlN).

Dans des modes particuliers de réalisation, le revêtement comprend une couche de protection réalisée en laque ou en résine acrylique et/ou nitrocellulosique, alkyde, polyuréthane ou époxy, superposée à la couche transparente et présente une épaisseur comprise entre 4 µm et 100 µm, une couche intermédiaire étant interposée entre la couche transparente et la couche de protection.

Dans des modes particuliers de réalisation, la couche intermédiaire est réalisée en Cr, Tl, CrₓO_{y} ou TiₓO_{y} et présente une épaisseur comprise entre 1 et 30 nm.

Dans des modes particuliers de réalisation, le revêtement comprend une couche de protection réalisée en Al₂O₃ et/ou en TlO₂ et présente une épaisseur comprise entre 1 et 100 nm.

Selon un autre objet, la présente invention concerne un procédé de fabrication d'une pièce d'habillage d'horlogerie ou de bijouterie comprenant les étapes successives suivantes de génération d'un revêtement sur une surface d'un substrat :
- dépôt d'une couche réfléchissante opaque sur une surface d'habillage d'un substrat, ladite couche présentant une épaisseur supérieure à 100 nm,
- dépôt d'une couche transparente, ladite couche présentant une épaisseur comprise entre 300 nm et 500 nm.

Dans des modes particuliers de mise en oeuvre, le procédé comporte une étape de structuration de la surface d'habillage du substrat de sorte à former un motif prédéfini.

Dans des modes particuliers de mise en oeuvre, le dépôt de la couche réfléchissante est réalisé par dépôt galvanique d'une couche de Ni, Au, Ag, Rh, Ru ou Cu.

Dans des modes particuliers de mise en oeuvre, le dépôt de la couche réfléchissante est réalisé par dépôt PVD d'une couche de Cr ou Ti.

Dans des modes particuliers de mise en oeuvre, le dépôt de la couche transparente est réalisé par dépôt PVD d'une couche de SiO₂, TiO₂, CrₓC_{y}, Al₂O₃, HfO₂, ZrO₂, Ta₂O₅, SnO₂, ITO, ZnO, MgO, Si₃N₄ ou AIN.

Dans des modes particuliers de mise en oeuvre, le procédé comprend une étape de dépôt d'une couche de protection sous la forme d'une laque ou d'une résine, le procédé comprenant en outre une étape de dépôt d'une couche intermédiaire réalisée après l'étape de dépôt de la couche transparente et avant l'étape de dépôt de la couche de protection.

Dans des modes particuliers de mise en oeuvre, le procédé comporte une étape de dépôt d'une couche de protection réalisée en Al₂O₃ et/ou en TlO₂ par procédé ALD, de sorte à présenter une épaisseur comprise entre 1 et 100 nm.

### Brève description des figures

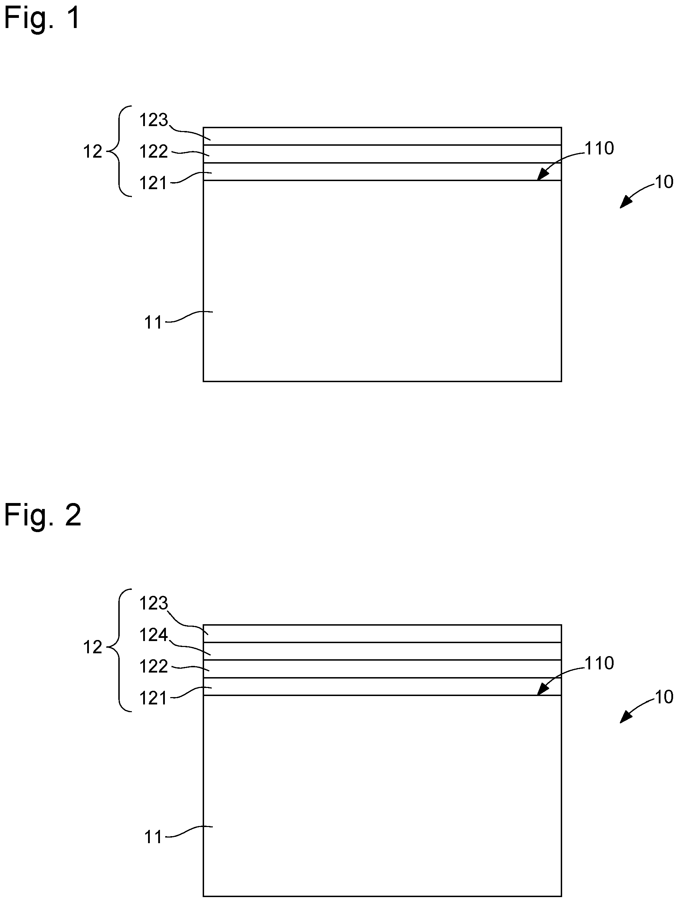

D'autres caractéristiques et avantages de l'invention apparaîtront à la lecture de la description détaillée suivante donnée à titre d'exemple nullement limitatif, en référence aux figures 1 et 2 annexées représentant schématiquement une vue de section d'une pièce d'habillage selon des exemples de réalisation de l'invention.

Il y a lieu de noter que, pour des raisons de clarté, les figures ne sont pas dessinées à l'échelle.

### Description détaillée de l'invention

Comme visible sur les figures 1 et 2, la présente invention concerne une pièce d'habillage 10 comprenant un substrat 11 comportant, sur une surface d'habillage 110, un revêtement 12 goniochromatique composé de plusieurs couches successivement superposées permettant de conférer à la pièce d'habillage 10 une couleur différente selon l'angle d'observation de la pièce d'habillage.

Le substrat 11 peut être réalisé dans un matériau métallique, tel qu'en alliage de cuivre, de fer, d'or ou d'argent, ou dans un matériau céramique.

La surface d'habillage 110 du substrat 11 peut avantageusement comporter des structurations (non visible sur la figure 1) formées par des creux et des saillies. De telles structurations peuvent réalisées par usinage laser ou mécanique, ou par frappe. Avantageusement, les structurations peuvent être des stries définissent un motif prédéterminé, par exemple un motif en nid d'abeille, un quadrillage, une spirale ou des cercles concentriques, des lignes parallèles, un soleillage, etc. Alternativement, les structurations peuvent former un nuage de points.

Grâce à cette caractéristique, il est possible d'obtenir un décor complexe, générant un aspect esthétique attrayant dont les angles influencent la réflexion de la lumière et donc la couleur perçue. En effet, les creux présentent alors des couleurs différentes des saillies.

La ou les éventuelles portions non structurées, dites « portions planes », présentent préférentiellement une couleur unie couleurs différente de celles desdits creux et saillies.

La surface d'habillage 110 du substrat 11 peut en outre présenter un traitement afin de modifier sa rugosité, tel que du sablage, du ponçage, microbillage, etc.

Sur le substrat 11 est déposée une couche réfléchissante 121, opaque ou semi-opaque réalisée en matériau métallique, tel qu'en Ni, Au, Ag, Rh, Ru, Cu, Cr ou Ti. Cette couche réfléchissante 121 présente une épaisseur d'au moins 100 nm.

La couche réfléchissante 121 peut être déposée par procédé PVD, par galvanisation ou par tout autre procédé approprié de dépôt de couche mince. Il y a lieu de noter que la couche réfléchissante 121 peut être formée par une unique couche mince ou par un empilement de couches.

Comme le montre la figure 1, une couche transparente 122 est superposée à la couche réfléchissante 121. Avantageusement, la couche réfléchissante 121 favorise l'accroche de la couche transparente 122.

La couche transparente 122 peut également être semi-transparente. La transparence de la couche transparente 122 dépend de son indice de réfraction.

La couche transparente 122 est réalisée en SiO₂, TiO₂, CrₓC_{y}, Al₂O₃, HfO₂, ZrO₂, Ta₂O₅, SnO₂, ITO, ZnO, MgO, Si₃N₄ ou AlN. Préférentiellement, la couche transparente 122 est réalisée en SiO₂, notamment pour des raisons économiques, de facilité de mise en oeuvre et de répétabilité.

Préférentiellement, la couche transparente 122 est déposée sur la couche réfléchissante 121 par procédé PVD.

Avantageusement, la couche transparente 122 présente avantageusement une épaisseur comprise entre 300 nm et 500 nm afin de générer un phénomène d'interférences permettant de conférer au revêtement 12 le caractère goniochromatique.

Dans un exemple préféré de réalisation de l'invention, le revêtement 12 peut en outre avantageusement comporter une couche de protection 123 superposée à la couche transparente 122. La couche peut être réalisée en laque ou en résine acrylique, nitro-cellulosique, alkyde, polyuréthane ou époxy.

L'ajout d'une telle couche de protection 123, par exemple présentant une épaisseur comprise entre 4 µm et 100 µm permet de protéger la couche de réflexion et la couche transparente 122 d'éventuelles agressions chimiques et/ou mécaniques.

Alternativement, la couche de protection 123 peut être réalisée en Al₂O₃ ou en TlO₂ déposée par procédé ALD, son épaisseur étant alors de quelques nanomètres, par exemple comprise entre 1 et 100 nm. Par ailleurs, la couche de protection 123 peut également être constitué par un empilement de couches réalisées en Al₂O₃ et en TlO₂.

Il y a lieu noter que la couche de protection 123 n'est pas essentielle, et que dans des exemples de réalisation de l'invention, le revêtement 12 présenter un caractère goniochromatique sans couche de protection 123.

Avantageusement, comme le montre la figure 2, la pièce d'habillage 10 peut comporter une couche intermédiaire 124 interposée entre la couche transparente 122 et la couche de protection 123 lorsque cette dernière est réalisée en laque ou en résine. Cette couche intermédiaire 124 est réalisée en Cr, Tl, CrₓO_{y} ou TiₓO_{y} et présente une épaisseur comprise entre 1 et 30 nm. Les indices de réfraction de la couche transparente 122 et de la couche de protection 123 étant très proches l'un de l'autre, la couche intermédiaire 124 permet d'obtenir l'effet interférentiel souhaité et par conséquent la création du caractère goniochromatique du revêtement 12. En effet, sans la couche intermédiaire 124 pour séparer la couche transparente 122 de la couche de protection 123, l'addition des épaisseurs respectives de ces dernières serait trop importante pour générer l'effet interférentiel recherché.

La couche intermédiaire 124 est préférentiellement déposée par procédé PVD.

Lorsque la couche de protection 123 est réalisée par procédé ALD, la pièce d'habillage 10 ne nécessite pas de couche intermédiaire 124 telle que précédemment décrite.

La pièce d'habillage 10 peut être obtenue par la mise en oeuvre du procédé de fabrication décrit ci-après. Les étapes successives de ce procédé consistent en la formation du revêtement 12 goniochromatique sur la surface d'habillage 110 du substrat 11.

Plus spécifiquement, le procédé comprend les étapes successives suivantes :
- dépôt d'une couche réfléchissante 121 opaque sur une surface d'habillage 110 d'un substrat 11, de sorte que ladite couche présente une épaisseur supérieure à 100 nm,
- dépôt d'une couche transparente 122 sur la couche réfléchissante 121, de sorte que ladite couche transparente 122 présente une épaisseur comprise entre 300 nm et 500 nm.

Le dépôt de la couche réfléchissante 121 est réalisé, par exemple, par galvanoplastie si elle est réalisée en Ni, Au, Ag, Rh, Ru ou Cu ou par procédé PVD si elle est réalisée en Cr ou Ti.

La couche transparente 122 est préférentiellement déposée par procédé PVD.

Dans un exemple préféré de mise en oeuvre de l'invention, le procédé de fabrication peut comporter une étape de dépôt d'une couche de protection 123. Cette couche de protection 123 peut être déposée sous la forme d'une laque ou d'une résine et présenter une épaisseur comprise entre 4 µm et 100 µm. Dans ce cas, le procédé comporte une étape de dépôt d'une couche intermédiaire 124 réalisée après l'étape de dépôt de la couche transparente 122 et avant l'étape de dépôt de la couche de protection 123.

Alternativement, l'étape de dépôt de la couche de protection 123 peut être réalisée par procédé ALD, directement à la suite de l'étape de dépôt de la couche transparente 122, la couche de protection 123 présentant alors une épaisseur de quelques nanomètres, par exemple entre 1 et 100 nm. Comme décrit ci-avant, la couche de protection 123 peut être réalisée par un empilement de couches de Al₂O₃ et TlO₂.

La pièce d'habillage 10 selon la présente invention est avantageusement formée par un cadran d'une montre.

Il y a lieu de noter que le revêtement 12 est préférentiellement configuré de sorte à conférer une couleur uniforme à la pièce d'habillage 10 au niveau de la ou des portions planes de la surface d'habillage 110.

En particulier, la couche transparente 122, et éventuellement la couche intermédiaire 124, présente préférentiellement une épaisseur constante, de sorte que la couleur perçue du revêtement 12 soit uniforme sur l'ensemble de la surface d'habillage 110 du substrat 11, quel que soit l'angle d'observation, à l'exception des éventuelles portions structurées de ladite surface d'habillage 110.

## Revendications

1. Pièce d'habillage (10) **caractérisée en ce qu'**elle comprend un substrat (11) comportant, sur une surface d'habillage (110), un revêtement (12) goniochromatique composé des couches suivantes successivement superposées :
- une couche réfléchissante (121) opaque ou semi-opaque présentant une épaisseur supérieure à 100 nm,
- une couche transparente (122) ou semi transparente, présentant une épaisseur comprise entre 300 nm et 500 nm.

2. Pièce d'habillage (10) selon la revendication 1, dans laquelle la surface d'habillage (110) du substrat (11) comporte des structurations formées par des creux et des saillies.

3. Pièce d'habillage (10) selon la revendication 1 ou 2, dans laquelle la surface d'habillage (110) du substrat (11) comporte une ou des portions planes, le revêtement (12) étant configuré de sorte à conférer une couleur uniforme à la pièce d'habillage (10) au niveau de ladite ou desdites portions planes de la surface d'habillage (110).

4. Pièce d'habillage (10) selon l'une des revendications 1 à 3, dans laquelle la couche réfléchissante (121) est réalisée en matériau métallique choisi parmi : Ni, Au, Ag, Rh, Ru, Cu, Cr et Ti.

5. Pièce d'habillage (10) selon l'une des revendications 1 à 4, dans laquelle la couche transparente (122) est réalisée dans un matériau choisi parmi : SiO₂, TiO₂, CrₓC_{y}, Al₂O₃, HfO₂, ZrO₂, Ta₂O₅, SnO₂, ITO, ZnO, MgO, Si₃N₄ ou AIN.

6. Pièce d'habillage (10) selon l'une des revendications 1 à 5, dans laquelle le revêtement (12) comprend une couche de protection (123) réalisée en laque ou en résine acrylique et/ou nitrocellulosique, alkyde, polyuréthane ou époxy, superposée à la couche transparente (122) et présentant une épaisseur comprise entre 4 et 100 µm, une couche intermédiaire (124) étant interposée entre la couche transparente (122) et la couche de protection (123).

7. Pièce d'habillage (10) selon la revendication 6, dans laquelle la couche intermédiaire (124) est réalisée en Cr, Tl, CrₓO_{y} ou TiₓO_{y} et présente une épaisseur comprise entre 1 et 30 nm.

8. Pièce d'habillage (10) selon l'une des revendications 1 à 5, dans laquelle le revêtement (12) comprend une couche de protection (123) réalisée en Al₂O₃ et/ou en TlO₂ et présente une épaisseur comprise entre 1 et 100 nm.

9. Procédé de fabrication d'une pièce d'habillage (10) d'horlogerie ou de bijouterie **caractérisé en ce qu'**il comprend les étapes successives suivantes de génération d'un revêtement (12) sur une surface d'un substrat (11):
- dépôt d'une couche réfléchissante (121) opaque sur une surface d'habillage (110) d'un substrat (11), ladite couche présentant une épaisseur supérieure à 100 nm,
- dépôt d'une couche transparente (122), ladite couche présentant une épaisseur comprise entre 300 nm et 500 nm.

10. Procédé de fabrication selon la revendication 9, comprenant une étape de structuration de la surface d'habillage (110) du substrat (11) de sorte à former un motif prédéfini.

11. Procédé de fabrication selon la revendication 9 ou 10, dans lequel le dépôt de la couche réfléchissante (121) est réalisé par dépôt galvanique d'une couche de Ni, Au, Ag, Rh, Ru ou Cu.

12. Procédé de fabrication selon la revendication 9 ou 10, dans lequel le dépôt de la couche réfléchissante (121) est réalisé par dépôt PVD d'une couche de Cr ou Ti.

13. Procédé de fabrication selon l'une des revendications 9 à 12, dans lequel le dépôt de la couche transparente (122) est réalisé par dépôt PVD d'une couche de SiO₂, TiO₂, CrₓC_{y}, Al₂O₃, HfO₂, ZrO₂, Ta₂O₅, SnO₂, ITO, ZnO, MgO, Si₃N₄ ou AIN.

14. Procédé de fabrication selon l'une des revendications 9 à 13, comprenant une étape de dépôt d'une couche de protection (123) sous la forme d'une laque ou d'une résine, le procédé comprenant en outre une étape de dépôt d'une couche intermédiaire (124) réalisée après l'étape de dépôt de la couche transparente (122) et avant l'étape de dépôt de la couche de protection (123).

15. Procédé de fabrication selon l'une des revendications 9 à 13, comprenant une étape de dépôt d'une couche de protection (123) réalisée en Al₂O₃ et/ou en TlO₂ par procédé ALD, de sorte à présenter une épaisseur comprise entre 1 et 100 nm.
